# FASCICULE DE BREVET EUROPEEN

(11) **EP 1 922 752 B1**
(45) Date de publication et mention de la délivrance du brevet: **04.11.2015**
(21) Numéro de dépôt: 06794326.6
(22) Date de dépôt: 11.08.2006
(51) Int. Cl.: H01L 21/762

(54) **PROCEDE DE REPORT D'UNE COUCHE MINCE SUR UN SUPPORT**
VERFAHREN ZUM TRANSFER EINES DÜNNFILMS AUF EINEN TRÄGER
METHOD OF TRANSFERRING A THIN FILM ONTO A SUPPORT

(30) Priorité: 16.08.2005 FR 0508555
(43) Date de publication de la demande: 21.05.2008
(73) Titulaire: Commissariat à l'Énergie Atomique et aux Énergies Alternatives, 75015 Paris (FR)
(72) Inventeur: DEGUET, Chrystel, F-38330 Saint Ismier (FR); CLAVELIER, Laurent, F-38000 Grenoble (FR); DECHAMP, Jérôme, F-38120 Saint Egreve (FR)
(74) Mandataire: Colombo, Michel
(86) Numéro de dépôt international: PCT/FR2006/001945
(87) Numéro de publication internationale: WO 2007/020351

(56) Documents cités:
- WO-A-2004/001810
- US-A1- 2004 150 006
- US-A1- 2005 148 122
- US-B1- 6 893 936

## Description

L'invention concerne un procédé de report d'une couche mince sur un support. Par couche mince, on entend une couche d'épaisseur typiquement inférieure à 1 µm.

Dans le cadre de la réalisation de structures empilées formées notamment par des couches minces portées par un support (par exemple un substrat), il a déjà été proposé de réaliser le report d'une couche mince sur le support selon un procédé qui comprend les étapes principales suivantes :
- la formation d'une zone fragilisée à une profondeur donnée d'un substrat constitué du matériau qui doit former la couche mince, par exemple par implantation d'un gaz à cette profondeur ;
- le collage du substrat implanté (dit substrat donneur) sur le support, par exemple par collage moléculaire ;
- la séparation du substrat donneur amputé de la couche mince (située entre la zone fragilisée et la surface initiale du substrat donneur) et du support qui porte alors la couche mince, par fracture (en général lors d'une étape de traitement thermique, couramment entre 200°C et 600°C) au niveau de la zone précédemment fragilisée.

Une telle solution est décrite par exemple dans la demande de brevet FR 2 681 472 ; elle permet par exemple de déposer une couche mince de silicium sur un support constitué d'un substrat en silicium recouvert d'une couche mince d'oxyde de silicium (SiO₂) isolant, afin d'obtenir une structure de type SOI (de l'anglais "*Silicon-On-Insulator*", c'est-à-dire silicium sur isolant).

Si le procédé brièvement décrit ci-dessus peut être appliqué tel quel dans le cas qui vient d'être mentionné, certaines difficultés peuvent survenir lors de l'application de manière classique de ce procédé dans des contextes différents, par exemple lorsque le substrat donneur et le support ont des caractéristiques mécaniques très différentes.

C'est notamment le cas lorsque l'on souhaite remplacer la couche mince de silicium par une couche mince de germanium (Ge) dont certaines propriétés électroniques sont avantageuses (telle que la mobilité des porteurs électriques, ce qui permet une amélioration des performances des circuits réalisés sur germanium).

La réalisation d'une telle structure (dénommée GeOI, pour "*Germanium-On-Insulator*", c'est-à-dire germanium sur isolant) au moyen du procédé précédemment évoqué a par exemple fait l'objet de l'article "*Germanium-On-Insulator* (GeOI) *Structure Realized by the Smart Cut™ Technology*", de F. Letertre *et al*., *in* MRS proceedings, 809 B4.4 (2004).

En l'espèce, l'application classique du procédé de report de la couche mince mentionnée précédemment conduit au collage d'un substrat de silicium sur un substrat implanté de germanium, en vue de leur séparation, au niveau de la zone fragilisée par l'implantation, par un traitement thermique. Cette solution est toutefois problématique du fait de la différence importante en termes de coefficient de dilatation thermique des deux matériaux utilisés (2,6.10⁻⁶/°C pour le silicium et 58.10⁻⁶/°C pour le germanium). En effet, le relâchement brutal, au moment de la fracture, des contraintes emmagasinées dans la structure peut occasionner la casse d'un substrat, voire des deux substrats.

Il est également proposé dans l'article précité de réaliser l'implantation dans une couche de germanium, dont l'épaisseur peut varier d'un à quelques microns et formée par épitaxie à la surface d'un substrat de silicium standard (de 750 µm d'épaisseur). Ainsi, la structure soumise au traitement thermique de séparation se comporte comme une homo-structure du fait de la faible épaisseur de germanium devant celle des deux substrats de silicium (voir par exemple WO 2004/001810).

Cette dernière solution est toutefois moins avantageuse sur le plan électronique du fait du nombre important de dislocations et d'une rugosité plus forte dans le germanium épitaxié.

Une autre solution connue pour réaliser une structure comportant une couche d'un premier matériau sur un substrat d'un second matériau est, après assemblage d'un substrat du premier matériau avec le substrat du second matériau, de procéder à un amincissement mécano-chimique du substrat du premier matériau. Cependant, cette technique ne peut être utilisée pour obtenir des couches minces de l'ordre du micron avec une bonne homogénéité d'épaisseur. En effet, par cette technique, plus l'amincissement est important, plus la couche résiduelle est inhomogène en épaisseur.

Afin de résoudre ces différents problèmes, et de proposer ainsi une solution qui combine notamment une mise en oeuvre simple, une bonne tenue mécanique lors de l'étape de traitement thermique de fracture et de bonnes propriétés cristallines électriques de la structure obtenue, l'invention prévoit un procédé de report d'une couche mince d'un premier matériau en germanium sur un premier support formé d'un second matériau en silicium, comprenant les étapes suivantes :
- fourniture d'une structure comportant une couche dont une partie au moins est issue d'un substrat massif de germanium ou obtenue par croissance épitaxiale en utilisant le substrat massif en Germanium en tant que graine et qui est solidaire d'un second support de silicium, l'épaisseur de la couche étant comprise entre 1 µm et 50 µm ;
- formation dans la couche par implantation d'au moins une espèce gazeuse d'une zone fragilisée enterrée à une profondeur donnée délimitant dans la structure la couche mince à reporter ;
- collage de la couche solidaire du second support sur le premier support ;
- fracture de la couche au niveau de la zone fragilisée incluant au moins une étape de traitement thermique.

Dans un tel procédé, le second support en silicium permet une bonne coopération mécanique avec le premier support en silicium (évolution similaire en température), indépendamment du matériau de la couche mince à reporter en germanium.

L'épaisseur de la couche de germanium est de préférence telle que le comportement mécanique en température de la structure obtenue après collage est imposé par le second support en silicum et le premier support en silicium. L'épaisseur de la couche est ainsi suffisamment fine pour ne pas intervenir dans le comportement mécanique en température de la structure obtenue après collage. L'étape de fracture se produit ainsi dans de bonnes conditions.

Selon l'invention, les épaisseurs mis en jeu, et notamment l'épaisseur de la couche de premier matériau en germanium, sont choisis de sorte que le relâchement des contraintes emmagasinées dans la structure au moment de la fracture n'entraine pas la casse de l'une ou l'autre des structures obtenues après fracture.

L'étape de fracture peut également comprendre une étape d'application de sollicitations mécaniques : forces mécaniques (insertion d'une lame, effort de traction et/ou flexion et/ou cisaillement) et/ou ultrasons ou micro-ondes ; l'étape de formation d'une zone fragilisée peut quant à elle être réalisée par implantation d'une ou plusieurs espèces gazeuses.

L'épaisseur de la couche solidaire du second support est par exemple inférieure à 15 % de l'épaisseur du second support, ce qui permet d'éviter toute influence mécanique notable de cette couche sur la structure issue de l'étape de collage, et notamment de limiter l'énergie élastique stockée dans la structure lors d'un traitement thermique. Cette épaisseur doit bien sûr être choisie en fonction de la différence des coefficients de dilatation thermique existant au sein de la structure et de la température que devra pouvoir supporter cette structure. Plus cette température sera basse, plus l'épaisseur de la couche solidaire du second support pourra être importante.

Le second matériau est du silicium. Le premier matériau est quant à lui du germanium.

L'épaisseur de la couche du premier matériau (avant fracture) est par exemple comprise entre 1 µm et 50 µm.

Selon un mode de réalisation présenté ci-après, le procédé peut comprendre une étape préalable de collage d'une plaque massive du premier matériau sur le second support, par exemple à chaud (typiquement entre 100°C et 200°C). Dans ce cas, la couche issue de la plaque et solidaire du second support peut être obtenue par une étape d'amincissement de la plaque du premier matériau, par exemple par amincissement mécano-chimique (qui peut être réalisé par un procédé dit « *grinding* », puis par polissage).

Le procédé peut aussi comprendre une étape de dépôt par épitaxie du premier matériau sur une partie de la couche (couche résiduelle) demeurant solidaire du second support après fracture. La qualité cristalline de la couche résiduelle étant bonne, celle de la couche épitaxiée le sera aussi.

Ainsi, on peut utiliser la couche épitaxiée pour un nouveau report de couche mince, par exemple au moyen des étapes suivantes :
- formation dans la couche épitaxiée d'une zone fragilisée enterrée ;
- collage de la couche épitaxiée sur un troisième support ;
- fracture de la couche épitaxiée au niveau de la zone fragilisée.

Selon une possibilité de mise en oeuvre du procédé, la couche solidaire du second support est intégralement issue du substrat massif. On assure ainsi une très bonne qualité cristalline pour l'ensemble de la couche.

Selon une autre possibilité de mise en oeuvre, la couche solidaire du second support comporte une couche épitaxiée du premier matériau. Comme déjà vu, ceci permet de continuer la réalisation de reports de couches minces sur la base d'une couche résiduelle, tout en conservant une bonne qualité cristalline grâce à la partie issue du substrat massif.

La couche solidaire du second support peut également comporter dans ce cas une couche épitaxiée d'un quatrième matériau d'une épaisseur telle que sa structure cristalline est impartie par le premier matériau. On peut ainsi utiliser cette couche à d'autres fonctions, sans qu'elle ne remette en cause la qualité cristalline des couches du premier matériau.

Par exemple, le procédé peut comprendre une étape d'élimination de la couche épitaxiée du premier matériau après fracture utilisant la couche épitaxiée du quatrième matériau comme couche d'arrêt.

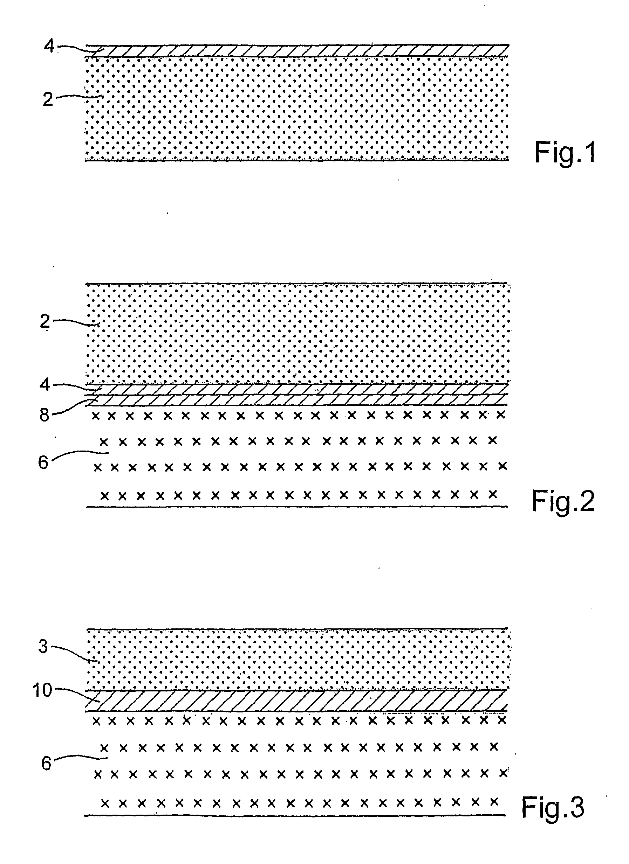

D'autres caractéristiques et avantages de la présente invention apparaîtront à la lumière de la description qui suit, faite en référence aux dessins annexés dans lesquels les figures 1 à 6 représentent différentes étapes d'un exemple de procédé conforme aux enseignements de l'invention.

Sur ces figures, les différentes couches apparaissent avec des épaisseurs schématiques, et non directement proportionnelles à la réalité, afin d'éclaircir leur présentation.

Les différentes étapes d'un exemple de procédé selon l'invention vont à présent être décrites en référence à ces figures.

Dans cet exemple, on utilise une plaque de germanium 2 massif (qui a donc de bonnes propriétés cristallines et électriques), ici d'un diamètre typique de 200 mm et d'une épaisseur de 750 µm, sur laquelle on a déposé une couche de surface d'oxyde de silicium 4 (SiO₂), par exemple par PECVD (pour « *Plasma Enhanced Chemical Vapor Deposition* », c'est-à-dire dépôt chimique en phase vapeur assisté par plasma) avec une chimie SiH₄ à 380°C, tel que représenté en figure 1.

En variante, on pourrait utiliser une plaque de germanium 2 sans couche de surface, ou une ou plusieurs couches de surface d'une nature différente.

La couche d'oxyde de silicium 4 peut éventuellement être préparée par densification (par exemple sous azote à 600°C pendant une heure). La structure plaque de germanium 2 - couche d'oxyde de silicium 4 est ensuite préparée pour le collage décrit ci-après, par exemple par nettoyage chimique et/ou polissage mécano-chimique pour un collage de type hydrophile.

Cette structure représentée à la figure 1 est ensuite collée sur un substrat 6 constitué d'un matériau dont le coefficient de dilatation thermique est différent de celui du germanium, en silicium (Si), qui forme un support, sur lequel a éventuellement été formée une couche, par exemple une couche d'oxyde de silicium (SiO₂) 8 formée par oxydation thermique pour faciliter le collage ultérieur (les collages oxyde/oxyde étant bien maîtrisés).

L'assemblage de la plaque de germanium 2 sur le substrat 6 en silicium (avec interposition éventuelle de couches d'oxyde de silicium 4, 8) est représenté lors de son collage en figure 2.

Ce collage peut être consolidé en étuve, par exemple à 200°C pendant deux heures.

On pourra avantageusement prévoir de réaliser ce collage à chaud, par exemple entre 100°C et 200°C, ce qui permettra de générer dans la structure des contraintes qui pourront venir compenser une partie des contraintes générées par les traitements thermiques ultérieurs et notamment le traitement thermique de fracture, réduisant ainsi les risques de casse.

La plaque de germanium 2 est alors amincie, de préférence par la combinaison d'une rectification suivie d'un polissage mécano-chimique et éventuellement d'une gravure chimique (le polissage permettant d'obtenir une bonne rugosité finale et la gravure chimique d'enlever les défauts créés par la rectification). D'autres techniques d'amincissement pourraient être utilisées, dans la mesure où elles garantissent l'intégrité de la structure (notamment qu'elles ne nécessitent pas de montée en température trop importante de la structure).

L'épaisseur finale de germanium doit être telle que le comportement mécanique de l'assemblage germanium/silicium soit essentiellement dicté par le silicium 6, de sorte que cet assemblage se comporte mécaniquement en température comme une homo-structure, et plus précisément de sorte que l'énergie élastique emmagasinée dans la structure pendant les traitements thermiques ultérieurs, et notamment lors du traitement thermique de fracture (et plus particulièrement au moment de la fracture de la structure), ne conduise pas à la casse de la structure. On choisira typiquement pour cette couche de germanium une épaisseur de 1 µm à 50 µm, par exemple de 20 µm.

On obtient alors la structure représentée à la figure 3, qui se compose ainsi essentiellement d'un substrat 6 formant support (ici en silicium, avec une épaisseur typique de 750 µm pour un substrat de 200 mm de diamètre), d'une couche intermédiaire 10 en oxyde de silicium (qui correspond à l'assemblage des deux couches en oxyde de silicium 4, 8 précédemment mentionnées) et d'une couche de germanium amincie 3, d'épaisseur réduite, par exemple de l'ordre de quelques micromètres à quelques dizaines de micromètres, par exemple de 20 µm.

Du fait du procédé utilisé pour son obtention, la rugosité et la structure cristalline de la couche amincie de germanium 3 sont proches de celles d'un substrat massif de germanium de sorte que les propriétés cristallines et électriques des couches minces formées comme décrit ci-après à partir de la couche amincie de germanium 3 seront particulièrement bonnes.

Comme expliqué dans la suite, l'épaisseur réduite de la couche amincie de germanium 3 et son collage sur le substrat de silicium 6 formant support permettent toutefois d'obtenir une structure ayant un comportement mécanique différent d'un substrat massif de germanium, ce qui sera avantageusement utilisé lors de l'étape de séparation décrite plus bas.

De plus, du fait de la plus grande conductivité thermique du silicium par rapport au germanium, cette structure (germanium/silicium) permet une meilleure évacuation de la chaleur pendant les étapes technologiques ultérieures que la solution utilisant un substrat de germanium.

La structure qui vient d'être décrite et représentée à la figure 3 constitue ainsi une structure donneuse particulièrement avantageuse qui va permettre le report d'une couche mince, ici de germanium, comme décrit à présent.

Avant collage sur le support qui doit recevoir la couche mince (pour l'essentiel un substrat de silicium dans l'exemple décrit ici), on peut préparer la structure précédemment réalisée et représentée à la figure 3 par les étapes suivantes :
- dépôt d'une couche de dioxyde de silicium (SiO₂), par exemple comme précédemment par PECVD ;
- densification facultative de la couche d'oxyde de silicium sous azote entre 400°C et 600°C pendant une heure ;
- nettoyage et/ou polissage mécano-chimique (pour améliorer la compatibilité avec un collage hydrophile).

En variante, il est bien sûr possible de ne pas déposer d'oxyde et de préparer directement la surface de germanium en vue de son collage sur le support devant recevoir la couche mince.

On forme par ailleurs une zone fragilisée 14 dans la couche amincie de germanium 3, à une profondeur qui correspond à l'épaisseur de la couche mince que l'on souhaite reporter (en général de l'ordre de quelques centaines de nanomètres, par exemple entre quelques dizaines et 1000 nm), par exemple par implantation d'espèces gazeuses, ici des ions hydrogènes (H⁺), avec une énergie comprise entre quelques keV et 250 keV et une dose comprise entre 3.10¹⁶ et 7.10¹⁶ H⁺/cm² ; typiquement, avec une énergie d'implantation de 100 keV et une dose de 5.10¹⁶, on obtient une profondeur d'implantation d'environ 700 nm.

L'étape d'implantation est par exemple réalisée après la formation de la couche d'oxyde de silicium (SiO₂) et avant nettoyage de la surface.

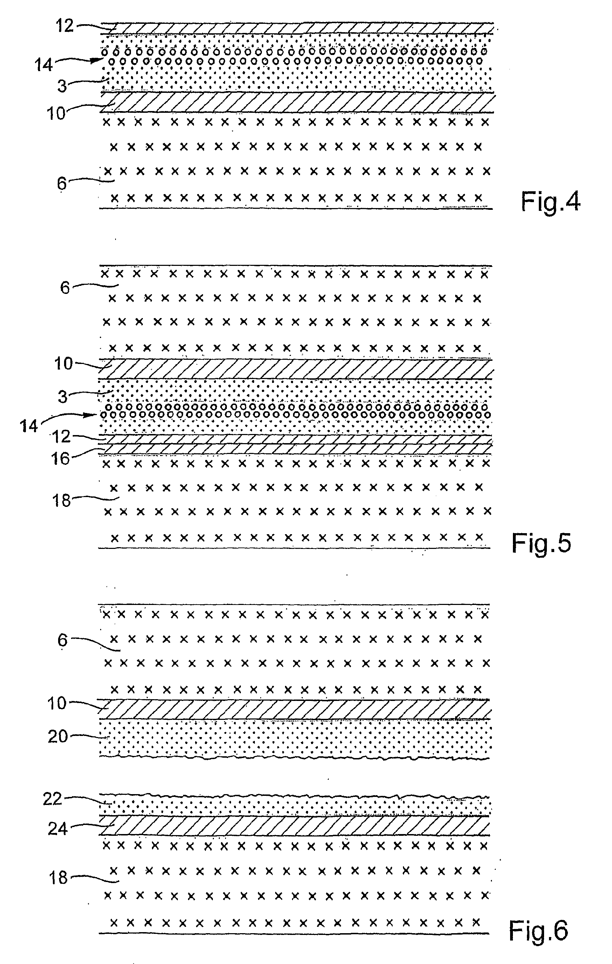

Après cette étape d'implantation et ces étapes éventuelles de préparation, la structure donneuse est donc construite comme représenté à la figure 4.

Cette structure est alors collée (au niveau de la couche d'oxyde de silicium 12 déposée sur la couche amincie de germanium 3, c'est-à-dire au niveau de la surface de cette dernière qui a subi l'implantation), par exemple par un collage hydrophile sur le support sur lequel doit être reportée la couche mince, constitué ici principalement d'un substrat en silicium 18 (en général d'épaisseur de l'ordre de 750 µm pour un substrat de 200 mm d'épaisseur), recouvert par une couche d'oxyde de silicium (SiO₂) 16.

On obtient ainsi l'assemblage représenté à la figure 5, que l'on va soumettre à une étape de traitement thermique, en général entre 200°C et 500°C (ici par exemple 330°C), afin de former une fracture au niveau de la zone fragilisée 14.

On réalise ainsi la séparation du support formé par le substrat en silicium 18 recouvert par la couche d'oxyde de silicium 16, qui porte désormais une couche mince de germanium 22 (issue de la couche amincie 3), et de la structure donneuse pelée de cette couche mince transférée, comme représenté à la figure 6.

Du fait de la faible épaisseur de la couche amincie de germanium 3 par rapport aux substrats en silicium 6, 18 (schématiquement représentée sur les figures, en pratique dans un rapport de l'ordre d'au moins 1 à 10) et de la compatibilité mécanique (ici en termes de dilatation thermique) des deux substrats 6, 18 (ici réalisés dans le même matériau), l'assemblage précédemment mentionné (et représenté à la figure 5) se comporte pour l'essentiel comme une homo-structure et a donc un bon comportement mécanique lors de l'étape de traitement thermique de fracture, sans risque majeur de formation de cassures.

Le relâchement de l'énergie élastique emmagasinée dans la structure au moment de la fracture est contrôlé et ne conduit pas à la casse des structures obtenues après fracture.

Après l'étape de fracture de la zone fragilisée (et par conséquent de séparation de l'assemblage de la figure 5), le substrat en silicium 18 recouvert de la couche d'oxyde de silicium 24 porte donc une couche mince de germanium 22 avec de bonnes propriétés électriques du fait que cette couche mince 22 est issue de la couche amincie de germanium 3 dont les propriétés électriques sont proches de celles de la plaque de germanium 2 initiale comme déjà mentionné.

On obtient ainsi, après d'éventuels traitements de finition du type polissage et recuit thermique, une plaque de GeOI (*i.e.* de germanium sur isolant) avec des propriétés électriques de la couche de germanium particulièrement intéressantes.

La structure donneuse, constituée principalement du substrat de silicium 6 et de la couche résiduelle de germanium 20 (couche amincie de germanium 3 pelée de la couche mince 22), peut alors être recyclée (par exemple par des techniques de rectification et/ou polissage) afin d'être à nouveau utilisée comme une structure donneuse pour le report d'une nouvelle couche mince de germanium, dans ce cas issue de la couche résiduelle 20 (en effet, même pelée de la couche mince 22, la structure donneuse est essentiellement constituée comme elle l'était au préalable, comme représenté à la figure 3).

Selon une possibilité de réalisation avantageuse, la couche amincie 3 ou la couche résiduelle 20 de germanium de la structure donneuse peut servir de germe pour l'épitaxie de germanium sur cette structure. Du fait de la qualité cristalline de la couche amincie (ou résiduelle), la qualité cristalline de cette couche épitaxiée sera proche de celle d'un substrat massif de germanium (souvent dénommé germanium « *bulk* »). On pourra ainsi réitérer le processus de report de couche mince en utilisant la couche épitaxiée.

En variante, on peut également prévoir d'épitaxier (sur la couche amincie 3 ou la couche résiduelle 20) successivement et itérativement du germanium (sur une épaisseur de quelques microns, par exemple 2 µm) et du silicium (typiquement avec une épaisseur de quelques nanomètres) pour former un empilement alternatif de ces deux matériaux : Si/Ge/Si/Ge etc.

La faible épaisseur des couches épitaxiées de silicium permet au germanium d'imposer son paramètre de maille et ainsi de maintenir une bonne qualité cristalline des couches épitaxiées de germanium.

Il faut en revanche s'assurer que l'épaisseur combinée des couches épitaxiées et de la couche de germanium initiale 3, 20 reste suffisamment faible pour que le comportement mécanique en température de la structure obtenue soit imposé par le substrat de silicium.

Selon cette variante, on peut se servir de la couche mince de silicium comme couche d'arrêt lors des transferts successifs.

On peut aussi utiliser le procédé suivant :
- on réalise l'implantation dans la couche epitaxiée de germanium située au sommet de l'empilement (couche extérieure) pour définir dans cette couche la couche mince à reporter ;
- on réalise le report de la couche mince comme indiqué ci-dessus ;
- on élimine le reste de la couche extérieure de germanium par gravure sélective (par exemple H₂O₂) ;
- on élimine ensuite la couche d'arrêt de silicium par gravure sélective (par exemple à base de TMAH - hydroxyde de tetramethylammonium) ;
- on réitère le processus sur la couche de germanium suivante.

Ce procédé permet d'éviter la mise en oeuvre d'un polissage après fracture et ainsi les inhomogénéités d'épaisseur qui en découlent généralement.

## Revendications

1. Procédé de report d'une couche mince (22) de germanium sur un premier support (18, 24) en silicium, comprenant les étapes suivantes :
- fourniture d'une structure comportant une couche (3) dont une partie au moins est issue d'un substrat massif de germanium ou obtenue par croissance épitaxiale en utilisant le substrat massif en Germanium en tant que graine et qui est solidaire d'un second support (6, 10) de silicium, l'épaisseur de la couche étant comprise entre 1 µm et 50 µm ;
- formation dans la couche (3) par implantation d'au moins une espèce gazeuse d'une zone fragilisée enterrée (14) à une profondeur donnée délimitant dans la structure la couche mince (22) à reporter ;
- collage de la couche (3) solidaire du second support (6, 10) sur le premier support (18, 24) ;
- fracture de la couche (3) au niveau de la zone fragilisée (14) incluant au moins une étape de traitement thermique.

2. Procédé de report d'une couche mince selon la revendication 1, dans lequel l'étape de fracture comprend également une étape d'application de sollicitations mécaniques.

3. Procédé de report d'une couche mince selon la revendication 1 ou 2, comprenant une étape préalable de collage d'une plaque massive (2) de germanium sur le second support (6, 8).

4. Procédé de report d'une couche mince selon la revendication 3, dans lequel l'étape de collage est réalisée à une température comprise entre 100 C° et 200 C°.

5. Procédé de report d'une couche mince selon la revendication 3 ou 4, comprenant une étape d'amincissement de ladite plaque (2) afin d'obtenir la couche (3) solidaire du second support (6, 10).

6. Procédé de report d'une couche mince selon l'une des revendications 1 à 5, comprenant une étape de dépôt de germanium par épitaxie sur une partie (20) de la couche (3) demeurant solidaire du second support (6) après fracture.

7. Procédé de report d'une couche mince selon la revendication 6, comprenant les étapes suivantes :
- formation dans la couche épitaxiée d'une zone fragilisée enterrée ;
- collage de la couche épitaxiée sur un troisième support ;
- fracture de la couche épitaxiée au niveau de la zone fragilisée.

8. Procédé de report d'une couche mince selon l'une des revendications 1 à 7, dans lequel la couche solidaire du second support est intégralement issue du substrat massif.

9. Procédé de report d'une couche mince selon l'une des revendications 1 à 7, dans lequel la couche solidaire du second support comporte une couche de germanium épitaxiée.

10. Procédé de report d'une couche mince selon la revendication 9, dans lequel la couche solidaire du second support comporte une couche épitaxiée d'un matériau d'une épaisseur telle que sa structure cristalline est impartie par le germanium.

11. Procédé de report d'une couche mince selon la revendication 10, comprenant une étape d'élimination de la couche de germanium épitaxiée après fracture utilisant la couche épitaxiée dudit matériau comme couche d'arrêt.

## Patentansprüche

1. Verfahren zum Transfer eines Dünnfilms (22) aus Germanium auf einen ersten Träger (18, 24) aus Silizium, umfassend die folgenden Schritte:
- Bereitstellung einer Struktur, umfassend einen Film (3), von dem mindestens ein Teil von einem massiven Germaniumsubstrat stammt oder durch epitaxiales Wachstum unter Verwendung des massiven Germaniumsubstrats als Kern erhalten wurde, und die mit einem zweiten Träger (6, 10) aus Silizium verbunden ist, wobei die Dicke des Films zwischen 1 µm und 50 µm beträgt;
- Bildung in dem Film (3) durch Implantation mindestens einer gasförmigen Spezies einer in einer gegebenen Tiefe eingegrabenen Bruchzone (14), die in der Struktur den zu transferierenden Dünnfilm (22) begrenzt;
- Kleben des mit dem zweiten Träger (6, 10) verbundenen Films (3) auf den ersten Träger (18, 24);
- Brechen des Films (3) im Bereich der Bruchzone (14), das mindestens einen Schritt der Wärmebehandlung einschließt.

2. Verfahren zum Transfer eines Dünnfilms nach Anspruch 1, bei dem der Schritt des Brechens auch einen Schritt des Anlegens von mechanischen Spannungen umfasst.

3. Verfahren zum Transfer eines Dünnfilms nach Anspruch 1 oder 2, umfassend einen vorherigen Schritt des Klebens einer massiven Germaniumplatte (2) auf den zweiten Träger (6, 8).

4. Verfahren zum Transfer eines Dünnfilms nach Anspruch 3, bei dem der Schritt des Klebens bei einer Temperatur zwischen 100°C und 200°C erfolgt.

5. Verfahren zum Transfer eines Dünnfilms nach Anspruch 3 oder 4, umfassend einen Schritt des Dünnmachens der Platte (2), um den mit dem zweiten Träger (6, 10) verbundenen Film (3) zu erhalten.

6. Verfahren zum Transfer eines Dünnfilms nach einem der Ansprüche 1 bis 5, umfassend einen Schritt des Aufbringens von Germanium durch Epitaxie auf einen Teil (20) des Films (3), der mit dem zweiten Träger (6) nach dem Bruch verbunden bleibt.

7. Verfahren zum Transfer eines Dünnfilms nach Anspruch 6, umfassend die folgenden Schritte:
- Bildung einer eingegrabenen Bruchzone in dem durch Epitaxie aufgebrachten Film;
- Kleben des durch Epitaxie aufgebrachten Films auf einen dritten Träger;
- Brechen des durch Epitaxie aufgebrachten Films im Bereich der Bruchzone.

8. Verfahren zum Transfer eines Dünnfilms nach einem der Ansprüche 1 bis 7, bei dem der mit dem zweiten Träger verbundene Film zur Gänze von dem massiven Substrat stammt.

9. Verfahren zum Transfer eines Dünnfilms nach einem der Ansprüche 1 bis 7, bei dem der mit dem zweiten Träger verbundene Film einen durch Epitaxie aufgebrachten Germaniumfilm umfasst.

10. Verfahren zum Transfer eines Dünnfilms nach Anspruch 9, bei dem der mit dem zweiten Träger verbundene Film einen durch Epitaxie aufgebrachten Film aus einem Material mit einer derartigen Dicke umfasst, dass ihre kristalline Struktur durch das Germanium verliehen wird.

11. Verfahren zum Transfer eines Dünnfilms nach Anspruch 10, umfassend einen Schritt der Beseitigung des durch Epitaxie aufgebrachten Germaniumfilms nach dem Bruch, wobei der durch Epitaxie aufgebrachte Film des Materials als Sperrfilm verwendet wird.

## Claims

1. Method for transferring a thin layer (22) of germanium onto a first silicon support (18, 24), comprising the following steps:
- providing a structure including a layer (3) at least one part of which is obtained from a bulk germanium substrate or obtained by epitaxial growth using the bulk germanium substrate as a seed and that is attached to a second silicon support (6, 10), the thickness of the layer being between 1 µm and 50 µm;
- forming in the layer (3), by implanting at least one gaseous species, a weakened zone (14) buried to a given depth delimiting in the structure the thin layer (22) to be transferred;
- bonding the layer (3) attached to the second support (6, 10) to the first support (18, 24);
- fracturing the layer (3) in the weakened zone (14), including at least one heat treatment step.

2. Thin layer transfer method according to Claim 1, wherein the fracture step also includes a step of applying mechanical loads.

3. Thin layer transfer method according to Claim 1 or 2, including a preliminary step of bonding a bulk plate (2) of germanium to the second support (6, 8).

4. Thin layer transfer method according to Claim 3, wherein the bonding step is carried out at a temperature between 100°C and 200°C.

5. Thin layer transfer method according to Claim 3 or 4, including a step of thinning said plate (2) in order to obtain the layer (3) attached to the second support (6, 10).

6. Thin layer transfer method according to one of Claims 1 to 5, including a step of epitaxial deposition of germanium on a portion (20) of the layer (3) remaining attached to the second support (6) after fracture.

7. Thin layer transfer method according to Claim 6, including the following steps:
- forming a buried weakened zone in the epitaxial layer;
- bonding the epitaxial layer onto a third support;
- fracturing the epitaxial layer at the weakened zone.

8. Thin layer transfer method according to one of Claims 1 to 7, wherein the layer attached to the second support is obtained entirely from the bulk substrate.

9. Thin layer transfer method according to one of Claims 1 to 7, wherein the layer attached to the second support includes an epitaxial germanium layer.

10. Thin layer transfer method according to Claim 9, wherein the layer attached to the second support includes an epitaxial layer of a material having a thickness such that its crystalline structure is imparted by the germanium.

11. Thin layer transfer method according to Claim 10, including a step of eliminating the epitaxial germanium layer after fracture using the epitaxial layer of said material as a stop layer.
